# EUROPEAN PATENT APPLICATION

(11) **EP 4 835 173 A1**
(43) Date of publication of application: **04.11.2026**
(21) Application number: 24927908.4
(22) Date of filing: 30.04.2024
(51) Int. Cl.: C30B 25/02, C30B 25/12

(54) **VACUUM INTERCONNECTION SYSTEM AND METHOD FOR SAMPLE EXCHANGE BETWEEN MOCVD AND MBE**

(30) Priority: 07.03.2024 CN 202410262284
(71) Applicant: Hunan Semicorepi Semiconductor Technology Co., Ltd., Changsha, Hunan 410000 (CN)
(72) Inventor: DU, Peng, Changsha, Hunan 410000 (CN); GONG, Xin, Changsha, Hunan 410000 (CN); CHENG, Kai, Changsha, Hunan 410000 (CN); LV, Wenli, Changsha, Hunan 410000 (CN); WEI, Wei, Changsha, Hunan 410000 (CN); CHEN, Fengwu, Changsha, Hunan 410000 (CN); XIAO, Hui, Changsha, Hunan 410000 (CN); NING, Shu, Changsha, Hunan 410000 (CN)
(74) Representative: Lorenz Seidler Gossel Part. mbB
(86) International application number: PCT/CN2024/090886
(87) International publication number: WO 2025/184971

(57) **Abstract**

A vacuum interconnection system for sample exchange between MOCVD and MBE, comprising an MOCVD growth chamber (1), an MOCVD transfer chamber (2), a flipping chamber (3), an MBE transfer chamber (4), and an MBE growth chamber (5) , which are sequentially docked with one another, wherein adjacent chambers are isolated from each other by isolation valves; the MOCVD transfer chamber (2) is provided with an MOCVD transfer chamber robot (21); the flipping chamber (3) is internally provided with a transfer plate (31), a filter plate (32), a transfer stage (33) which is liftable and rotatable, a first lifting assembly (34), and a second lifting assembly (35); the transfer plate (31) is provided with a plurality of wafer carrier positions (311); the filter plate (32) is provided with a plurality of wafer filter through-holes (321); a diameter of the wafer filter through-hole (321) is larger than a diameter of a wafer (100) and smaller than a diameter of a wafer carrier (101); an upper surface and a lower surface of the filter plate (32) are respectively provided with placement portions (322); one side of the flipping chamber (3) is docked with a robot box (6); the robot box (6) is internally provided with a flipping robot (61); and the MBE transfer chamber (4) is provided with an MBE transfer chamber robot (41). The present invention does not require contact with the growth surface of the wafer, thereby reducing the risk of wafer surface damage and contact contamination, and does not require clamping of the peripheral region of the wafer, thereby reducing the risk of fragmentation caused by compressive stress.

## Description

### Cross-Reference to Related Applications

The present invention is based on and claims priority from a Chinese patent application filed on March 7, 2024, with application number 202410262284.5 and entitled "Vacuum Interconnection System and Method for Sample Exchange between MOCVD and MBE", the entire disclosure of which is hereby incorporated by reference into the present invention as a part hereof.

### TECHNICAL FIELD

The present invention relates to epitaxial growth equipment and process methods, and in particular to a vacuum interconnection system and a method for sample exchange between MOCVD and MBE.

### BACKGROUND

Metal Organic Chemical Vapor Deposition (hereinafter referred to as MOCVD) and Molecular Beam Epitaxy (hereinafter referred to as MBE) have become mainstream epitaxial technologies for the preparation of compound semiconductor materials and their device structures, and are widely used in the research and mass production of optoelectronic and microelectronic chips. MOCVD technology uses organic compounds of Group III and Group II elements and hydrides of Group V and Group VI elements as source materials for crystal growth, and performs vapor phase epitaxy on a substrate by means of a thermal decomposition reaction. The vacuum degree in the growth chamber is about 100 Torr. This technology features a relatively high rate, relatively low costs, and relatively good control flexibility and process repeatability, making it suitable for high temperature growth materials represented by nitrides and phosphides. MBE technology, under ultra-high vacuum conditions (typically better than 10⁻¹⁰ Torr), heats the constituent elements of the crystal in corresponding effusion cells to form directional atomic beams or molecular beams that are incident onto a heated substrate for thin film growth. This technology features high material purity, controllable thickness, composition, and doping at the single atomic layer level, as well as smooth surfaces and interfaces, making it suitable for low-temperature growth materials represented by arsenides and antimonides. However, both MOCVD and MBE have their inherent disadvantages: MOCVD uses gaseous sources, which inevitably introduce impurities, resulting in a relatively poor vacuum degree and relatively inferior film quality; MBE, due to its high vacuum degree, has a slow growth rate and high operating costs, and its mass production capability is inferior to MOCVD.

MOCVD and MBE have considerable overlap in practical applications. The alternating growth method combining MOCVD and MBE can achieve complementary advantages. For example, high-quality active layers or low-resistance ohmic contact layers can be grown with MBE, while thicker transition layers or waveguide layers can be grown with MOCVD. This can significantly improve the growth quality and efficiency of materials, while providing a new platform for the mass production of high-performance device materials such as GaN radio frequency devices, long-wavelength VCSELs, DFB lasers, and deep ultraviolet optoelectronic devices.

MOCVD and MBE are independent systems with relatively significant differences in wafer holding formats: in MOCVD, the wafer is placed with the growth surface facing upward, and the back face of the wafer is in contact with and placed within individual wafer carriers; the air-flotation-driven rotating wafer carriers are then placed in a motor-driven revolving large graphite susceptor. In MBE, the wafer is placed with the growth surface facing downward, and the edge of the wafer is in contact with and placed within individual wafer positions on a molybdenum holder. Due to inherent process differences and vacuum degree differences, the graphite susceptor of MOCVD and the molybdenum holder of MBE cannot be exchanged or introduced into each other's systems. Currently, sample exchange between the two systems is performed manually, requiring exposure to the atmospheric environment. The sample surface is highly susceptible to oxidation or contamination by adsorbed particles, water vapor, organic substances, etc., leading to a decline in crystal quality, and additional etching or cleaning processes are required in the transfer process. Sample exchange between the two systems requires breaking vacuum followed by evacuating, and cooling down followed by heating up, resulting in long process time, low efficiency, and a high risk, which fails to fully leverage the advantages of the two systems.

Chinese Patent Document CN215628426U proposes a vacuum interconnection system for sample exchange between MOCVD and MBE. However, this technical solution does not specify a specific method for implementing the sample exchange. Chinese Patent Document CN219132311U further discloses use of a vacuum high-temperature multi-axis robot for sample exchange, which uses two clamping jaws moving toward each other to clamp the peripheral region of a wafer. However, in practical applications, the wafer is placed in recessed positions on an MOCVD graphite sub-susceptor or an MBE molybdenum holder, leaving no clearance at the wafer edge for the clamping jaws to pick up or release the wafer. The multi-axis robot is required to have translational motions along X, Y, and Z axes, as well as rotational functions around the X and Z axes. However, motors or cylinders for providing driving force are all mounted in the sample transfer chamber. In practice, it is difficult to find a motor or a cylinder that meets requirements for use in a 10⁻⁷ Torr vacuum and a 200°C high temperature environment.

Chinese patent document CN116377572A proposes a vacuum interconnection transfer system for sample exchange between MOCVD and MBE, where an electrostatic chuck on a first robotic arm is used to pick up and flip a wafer, and a second robotic arm is used to pick up and transfer a wafer carrier. Taking sample transfer from MOCVD to MBE as an example, the electrostatic chuck picks up the front side of the wafer from the MOCVD graphite susceptor in a non-contact manner and flips it, so that the growth surface of the wafer faces downward and is placed on the sample stage of a center calibration module. The wafer is pushed by a clamping assembly to correct its center position, and finally, the electrostatic chuck picks up the back side of the wafer and transfers it onto the MBE molybdenum holder. In the position correction process, the growth surface of the wafer inevitably slides and rubs against the sample stage, which is inconsistent with the original intention of adopting the electrostatic chuck to avoid surface damage and contact contamination of the wafer. Moreover, a vacuum electrostatic chuck typically has a maximum operating temperature of 100°C, making it difficult to meet the requirements for high temperature sample transfer.

### SUMMARY

The technical problem to be solved by the present invention is to overcome the deficiencies of the prior art, and to provide a vacuum interconnection system for sample exchange between MOCVD and MBE, which does not require contact with the growth surface of a wafer, thereby reducing the risk of wafer surface damage and contact contamination, and does not require clamping of the peripheral region of the wafer, thereby reducing the risk of fragmentation caused by compressive stress.

The present invention further provides a method for sample exchange between MOCVD and MBE. To solve the above technical problems, the present invention adopts the following technical solutions:
The vacuum interconnection system for sample exchange between MOCVD and MBE comprises an MOCVD growth chamber, an MOCVD transfer chamber, a flipping chamber, an MBE transfer chamber, and an MBE growth chamber, which are sequentially docked with one another, wherein adjacent chambers are isolated from each other by isolation valves; the MOCVD transfer chamber is provided with an MOCVD transfer chamber robot; the flipping chamber is internally provided with a transfer plate, a filter plate, a transfer stage which is liftable and rotatable, a first lifting assembly detachably connectable to the transfer plate or a molybdenum holder, and a second lifting assembly detachably connectable to the filter plate; the transfer plate is provided with a plurality of wafer carrier positions; the filter plate is provided with a plurality of wafer filter through-holes; a diameter of the wafer filter through-hole is larger than a diameter of a wafer and smaller than a diameter of a wafer carrier; an upper surface of the filter plate is provided with a placement portion for placing the molybdenum holder, and a lower surface of the filter plate is provided with a placement portion for placing the transfer plate; one side of the flipping chamber is docked with a robot box; the robot box is internally provided with a flipping robot; and the MBE transfer chamber is provided with an MBE transfer chamber robot.

In some embodiments of the present invention, a first positioning mechanism is provided between the transfer plate and the filter plate, and a second positioning mechanism is provided between the filter plate and the molybdenum holder.

In some embodiments of the present invention, the first positioning mechanism comprises a first positioning notch provided on the transfer plate and a second positioning notch provided on the filter plate; and the second positioning mechanism comprises a positioning pin provided on the filter plate and a positioning hole provided on the molybdenum holder; or alternatively, the second positioning mechanism comprises a positioning hole provided on the filter plate and a positioning pin provided on the molybdenum holder.

In some embodiments of the present invention, the first lifting assembly and the second lifting assembly each comprise a plurality of lifting rods; and the transfer plate, the molybdenum holder, and the filter plate are provided with slots for engaging with the lifting rods.

In some embodiments of the present invention, an outer periphery of the placement portion is provided with a protrusion, and the wafer filter through-holes are located within the placement portions.

In some embodiments of the present invention, the MOCVD transfer chamber robot, the MBE transfer chamber robot, the flipping robot, the transfer stage, the first lifting assembly, and the second lifting assembly are all capable of moving at a high temperature up to 800°C in a vacuum environment.

In some embodiments of the present invention, a drive part of the MOCVD transfer chamber robot is located outside the MOCVD transfer chamber and transmits motion through magnetic coupling; a drive part of the MBE transfer chamber robot is located outside the MBE transfer chamber and transmits motion through magnetic coupling.

In some embodiments of the present invention, the flipping robot comprises an upper clamping jaw and a lower clamping jaw separated by a predetermined gap.

A method for sample exchange between MOCVD and MBE is provided, comprising the following steps:
S1. bringing an MOCVD growth chamber, an MOCVD transfer chamber, and a flipping chamber into communication; evacuating the three chambers to a first predetermined vacuum degree; using an MOCVD transfer chamber robot to transfer each wafer along with its wafer carrier from a graphite susceptor within the MOCVD growth chamber, to each wafer carrier position of a transfer plate; isolating the MOCVD growth chamber, the MOCVD transfer chamber, and the flipping chamber;
S2. driving a filter plate to descend and land on the transfer plate by a second lifting assembly, and aligning wafer filter through-holes with the wafer carrier positions;
S3. evacuating the flipping chamber to a second predetermined vacuum degree; bringing the flipping chamber and an MBE transfer chamber into communication; taking an empty molybdenum holder from the MBE transfer chamber by an MBE transfer chamber robot; if the empty molybdenum holder is already in a flipped state, proceeding directly to step S5; and if the empty molybdenum holder is in an unflipped state, transferring the empty molybdenum holder to a transfer stage by the MBE transfer chamber robot, then retracting the MBE transfer chamber robot, and rotating the transfer stage by a certain angle to align a wafer pick-up position with a flipping robot;
S4. taking the empty molybdenum holder from the transfer stage by the flipping robot; retracting the flipping robot by a certain distance, then flipping the empty molybdenum holder by 180° and returning the empty molybdenum holder to the transfer stage by the flipping robot; rotating the transfer stage by a certain angle to align the wafer pick-up position with the MBE transfer chamber robot; and retrieving the flipped empty molybdenum holder by the MBE transfer chamber robot;
S5. ascending the transfer stage; ascending a first lifting assembly to drive the transfer plate and the filter plate to a position suitable for the MBE transfer chamber robot; transferring the empty molybdenum holder onto the filter plate by the MBE transfer chamber robot; aligning wafer positions on the molybdenum holder with the wafer filter through-holes; and retracting the MBE transfer chamber robot;
S6. simultaneously clamping the transfer plate, the filter plate, and the molybdenum holder by the flipping robot; descending the first lifting assembly to separate from the transfer plate; retracting the flipping robot by a certain distance and then performing a 180° flip, letting the wafer on the wafer carrier to fall through the wafer filter through-hole into the wafer position on a lowermost molybdenum holder;
S7. returning the molybdenum holder, the filter plate, and the transfer plate by the flipping robot; ascending the first lifting assembly to support the molybdenum holder; retracting the flipping robot; ascending the second lifting assembly to lift the filter plate and the transfer plate thereabove, and separating them from the molybdenum holder; holding the molybdenum holder by the MBE transfer chamber robot; descending the first lifting assembly to separate from the molybdenum holder; retrieving the molybdenum holder by the MBE transfer chamber robot; and isolating the flipping chamber and the MBE transfer chamber.

In some embodiments of the present invention, the method further comprises the following steps:
S8. evacuating the MBE transfer chamber to a third predetermined vacuum degree; bringing the MBE transfer chamber and an MBE growth chamber into communication; transferring the molybdenum holder to the MBE growth chamber by the MBE transfer chamber robot; isolating the MBE transfer chamber and the MBE growth chamber; evacuating the MBE growth chamber to a fourth predetermined vacuum degree; and starting an MBE process;
S9. after the MBE process is completed, bringing the MBE growth chamber and the MBE transfer chamber into communication; retrieving the molybdenum holder from the MBE growth chamber by the MBE transfer chamber robot; isolating the MBE growth chamber and the MBE transfer chamber; bringing the MBE transfer chamber and the flipping chamber into communication; transferring the molybdenum holder to the flipping chamber by the MBE transfer chamber robot; ascending the first lifting assembly to support the molybdenum holder; retracting the MBE transfer chamber robot; isolating the MBE transfer chamber and the flipping chamber; descending the second lifting assembly to lower the filter plate and the transfer plate thereabove onto the molybdenum holder; simultaneously holding the molybdenum holder, the filter plate, and the transfer plate by the flipping robot; descending the first lifting assembly to separate from the molybdenum holder; descending the second lifting assembly to separate from the filter plate; retracting the flipping robot by a certain distance and then performing a 180° flip, letting the wafer on the molybdenum holder to fall through the wafer filter through-hole into the wafer carrier on a lowermost transfer plate;
S10. returning the transfer plate, the filter plate, and the molybdenum holder by the flipping robot; supporting the transfer plate by the first lifting assembly; retracting the flipping robot; ascending the second lifting assembly to lift the filter plate and the molybdenum holder thereabove, and separating them from the transfer plate; bringing the MOCVD growth chamber, the MOCVD transfer chamber, and the flipping chamber into communication; transferring, each wafer with its wafer carrier from the transfer plate within the flipping chamber to the graphite susceptor within the MOCVD growth chamber by the MOCVD transfer chamber robot; and isolating the MOCVD growth chamber, the MOCVD transfer chamber, and the flipping chamber.

Compared with the prior art, the present invention has the following advantages:
The vacuum interconnection system for sample exchange between MOCVD and MBE disclosed in the present invention does not require contact with the growth surface of the wafer during wafer transfer and flipping, thereby reducing the risk of wafer surface damage and contact contamination, and does not require clamping of the peripheral region of the wafer, thereby reducing the risk of fragmentation caused by compressive stress. It enables clean, efficient, and safe transfer of wafers between different types of carriers, achieving bidirectional automatic sample transfer from MOCVD to MBE or from MBE to MOCVD, truly achieving vacuum interconnection and process interconnection between MOCVD and MBE, fully leveraging the advantages of both types of equipment, significantly improving process performance and production efficiency, and providing possibilities for the development of special materials and novel devices.

The method for sample exchange between MOCVD and MBE disclosed in the present invention achieves clean, efficient, and safe transfer of wafers between different types of carriers, realizes bidirectional automatic sample exchange from MOCVD to MBE or from MBE to MOCVD, truly accomplishes vacuum interconnection and process interconnection between MOCVD and MBE, fully leverages the advantages of both types of equipment, significantly improves process performance and production efficiency, and provides possibilities for the development of special materials and novel devices.

### BRIEF DESCRIPTION OF THE DRAWINGS

FIG. 1 is a schematic structural diagram of a vacuum interconnection system for sample exchange between MOCVD and MBE according to the present invention.
FIG. 2 is a schematic structural diagram of a graphite susceptor involved in the present invention.
FIG. 3 is a schematic structural diagram of a molybdenum holder involved in the present invention.
FIG. 4a is a schematic structural diagram of an upper surface of a transfer plate involved in the present invention.
FIG. 4b is a schematic structural diagram of a lower surface of a transfer plate involved in the present invention.
FIG. 5a is a schematic structural diagram of an upper surface of a filter plate involved in the present invention.
FIG. 5b is a schematic structural diagram of a lower surface of a filter plate involved in the present invention.
FIG. 6 is a schematic structural diagram of a transfer stage involved in the present invention.
FIG. 7 is a schematic diagram of a process of transferring a wafer and its wafer carrier from the graphite susceptor to the transfer plate involved in the present invention.
FIG. 8 is a schematic diagram of a process of positioning a filter plate and a transfer plate involved in the present invention.
FIG. 9a is a schematic diagram of a process of transferring an empty molybdenum holder to a transfer stage involved in the present invention.
FIG. 9b is a schematic diagram of a process of a transfer stage rotating by 90° and a flipping robot flipping a molybdenum holder by 180° involved in the present invention.
FIG. 10 is a schematic diagram of a process of a flipped empty molybdenum holder landing on a filter plate involved in the present invention.
FIG. 11 is a schematic diagram of a process of a flipping robot flipping combined carrier plates by 180° involved in the present invention.
FIG. 12 is a schematic diagram of a process of transferring a flipped molybdenum holder and wafers to an MBE transfer chamber involved in the present invention.

Reference numerals in the drawings denote:
100. wafer; 101. wafer carrier; 102. graphite susceptor; 200. molybdenum holder; 201. positioning hole; 202. slot; 203. wafer position;
1. MOCVD growth chamber; 2. MOCVD transfer chamber; 21. MOCVD transfer chamber robot; 3. flipping chamber; 31. transfer plate; 311. wafer carrier position; 312. first positioning notch; 32. filter plate; 321. wafer filter through-hole; 322. placement portion; 323. second positioning notch; 324. positioning pin; 325. protrusion; 33. transfer stage; 34. first lifting assembly; 35. second lifting assembly; 4. MBE transfer chamber; 41. MBE transfer chamber robot; 5. MBE growth chamber; 6. robot box; 61. flipping robot; 611. upper clamping jaw; 612. lower clamping jaw; and 7. gate valve.

### DETAILED DESCRIPTION OF THE EMBODIMENTS

In the description of the present invention, it should be understood that terms such as "upper", "lower", "front", "rear", "top", "bottom", "inner", "outer", and the like indicating orientations or positional relationships are based on the orientations or positional relationships shown in the drawings, and are merely for convenience of describing the present invention and simplifying the description, and are not intended to indicate or imply that the devices or elements referred to must have a specific orientation, be constructed or operated in a specific orientation, and therefore should not be construed as limiting the present invention.

Furthermore, the terms "first" and "second" are used merely for descriptive purposes and are not to be construed as indicating or implying relative importance or implicitly indicating the number of technical features indicated. Thus, features defined with "first" or "second" may explicitly or implicitly include one or more of that feature. In the description of the present invention, the meaning of "plurality" is two or more, unless otherwise explicitly and specifically defined.

In the present invention, unless otherwise explicitly specified and defined, terms such as "connected" should be understood in a broad sense, for example, it may be a fixed connection, a detachable connection, or integral; it may be a mechanical connection or an electrical connection; it may be a direct connection or an indirect connection through an intermediate medium; it may be an internal communication between two elements or an interaction relationship between two elements. For those of ordinary skill in the art, the specific meanings of the above terms in the present invention may be understood according to specific circumstances.

The present invention will be further described below in detail with reference to the drawings and detailed embodiments of the description.

### Embodiment I

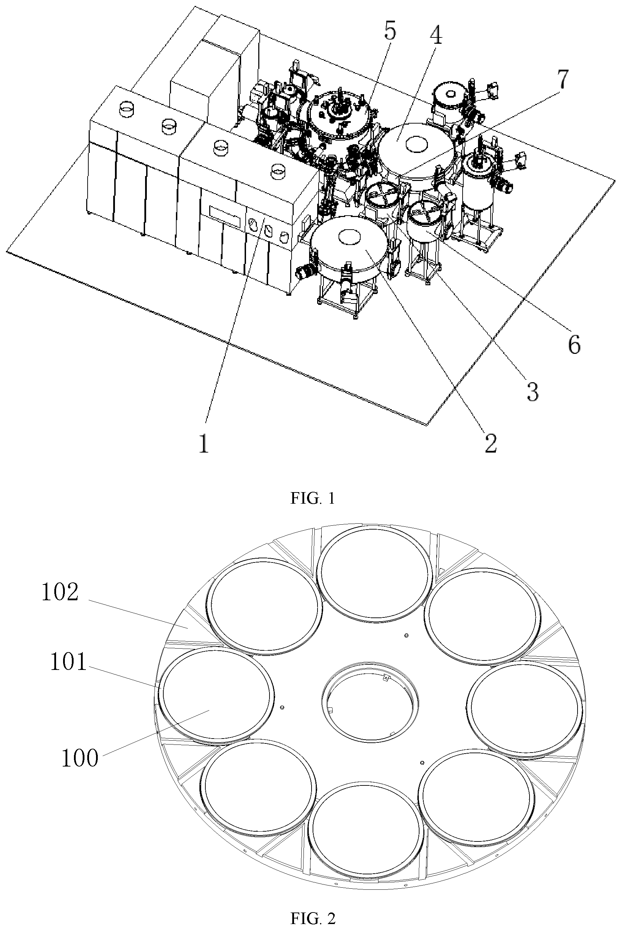

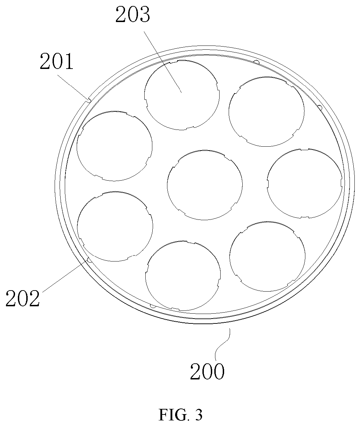

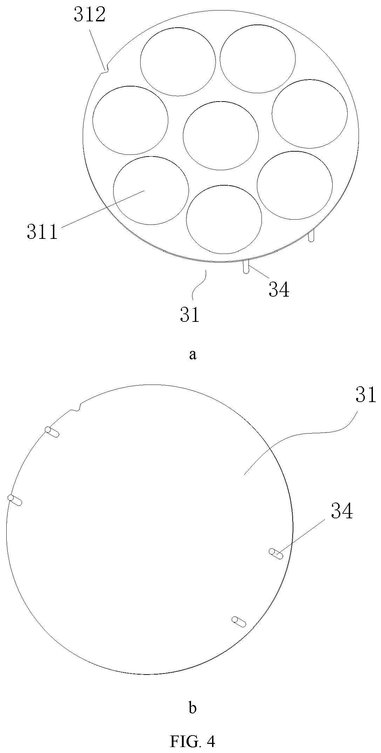

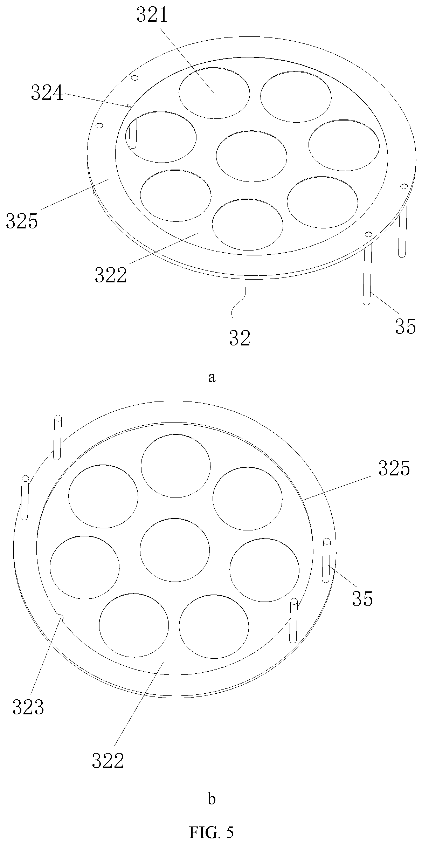

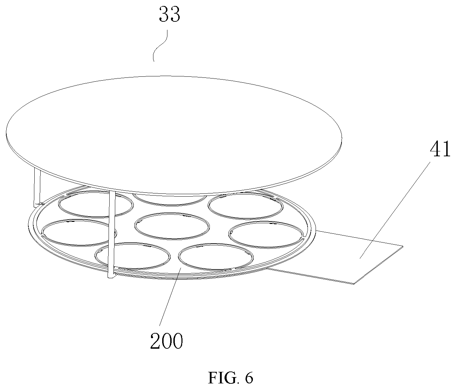

FIG. 1 to FIG. 6 show an embodiment of a vacuum interconnection system for sample exchange between MOCVD and MBE according to the present invention. The vacuum interconnection system for sample exchange between MOCVD and MBE of this embodiment includes an MOCVD growth chamber 1, an MOCVD transfer chamber 2, a flipping chamber 3, a robot box 6, an MBE transfer chamber 4, and an MBE growth chamber 5. The MOCVD growth chamber 1, the MOCVD transfer chamber 2, the flipping chamber 3, the MBE transfer chamber 4, and the MBE growth chamber 5 are sequentially docked with one another. The robot box 6 is arranged on one side of the flipping chamber 3. The line on which the MOCVD transfer chamber 2, the flipping chamber 3, and the MBE transfer chamber 4 are located is perpendicular to the line on which the robot box 6 and the flipping chamber 3 are located. Of course, in other embodiments, the chambers may also be arranged in other different manners. Adjacent chambers are preferably isolated from each other by gate valves 7. When the gate valve 7 is opened, adjacent chambers are in communication; conversely, when the gate valve 7 is closed, adjacent chambers are isolated, i.e., no longer in communication. It is understood that each chamber is provided with a vacuum control module including a vacuum pump, a vacuum gauge, a venting line, etc. The flipping chamber 3 and the robot box 6 may share a vacuum control module.

The vacuum degree of the MBE growth chamber 5 is generally 5×10⁻¹¹ Torr to 10⁻¹⁰ Torr. The vacuum degree of the MBE transfer chamber 4 is generally 5×10⁻¹⁰ Torr to 10⁻⁸ Torr. The vacuum degree of the flipping chamber 3 and the robot box 6 is generally 5×10⁻⁹ Torr to 10⁻⁷ Torr. The vacuum degree of the MOCVD transfer chamber 2 is generally 5×10⁻⁸ Torr to 5×10⁻² Torr. The vacuum degree of the MOCVD growth chamber 1 is generally 10⁻² Torr to 100 Torr. Each chamber is equipped with different combinations of vacuum pumps according to the required vacuum degree, including but not limited to cryopumps, ion pumps, turbo molecular pumps, dry scroll pumps, etc. Each chamber is equipped with different vacuum gauges according to the required vacuum degree, including but not limited to Pirani gauges, nude ionization gauges, full-range vacuum gauges, etc. The gate valves 7 for isolating the chambers meet the requirements for ultra-high vacuum applications and support operation at a high temperature of 200°C.

The MOCVD transfer chamber 2 is provided with an MOCVD transfer chamber robot 21, and the MBE transfer chamber 4 is provided with an MBE transfer chamber robot 41. Both the MOCVD transfer chamber robot 21 and the MBE transfer chamber robot 41 have 360° rotation and telescopic extension and retraction functions, and support high temperature motion at 800°C in a vacuum environment. Preferably, the MOCVD transfer chamber robot 21 and the MBE transfer chamber robot 41 are made of high-purity and high-strength materials capable of withstanding a high temperature of 800°C, including but not limited to stainless steel, tantalum, molybdenum, ceramics, etc. The MOCVD transfer chamber robot 21 and the MBE transfer chamber robot 41 may be driven by motors or cylinders. The motors or cylinders are disposed outside the vacuum chambers and transmit motion through magnetic coupling. Positioning of the MOCVD transfer chamber robot 21 and the MBE transfer chamber robot 41 is achieved by adopting means including but not limited to a positioning hole 201, a first positioning notch 312, a second positioning notch 323, and a positioning pin 324, and positioning options such as photoelectric sensor positioning or CCD camera vision positioning may also be adopted.

Within the flipping chamber 3, from bottom to top, are sequentially provided with a transfer plate 31, a filter plate 32, a liftable and rotatable transfer stage 33, a first lifting assembly 34 for driving the transfer plate 31 or a molybdenum holder 200 to lift and descend and capable of being separated from the transfer plate 31 or the molybdenum holder 200, and a second lifting assembly 35 for driving the filter plate 32 to lift and descend and capable of being separated from the filter plate 32. The first lifting assembly 34 and the second lifting assembly 35 preferably use first support rods and second support rods, respectively. The transfer plate 31, the filter plate 32, and the molybdenum holder 200 are provided with slots 202 corresponding to the support rods. The structure is simple and compact, facilitating automatic engagement and disengagement in a high temperature environment. Of course, in other embodiments, the lifting assemblies may also take other forms.

The transfer plate 31, the first support rods, the filter plate 32, the second support rods, and the transfer stage 33 are preferably made of high-purity and high-strength materials capable of withstanding a high temperature of 800°C, including but not limited to stainless steel, tantalum, molybdenum, ceramics, etc. The lifting of the first support rods, the lifting of the second support rods, and the lifting and rotation of the transfer stage 33 may all be driven by motors or cylinders. The motors or cylinders are disposed outside the vacuum chambers and transmit motion through magnetic coupling. Each group of the first support rods and the second support rods may include 2, 3, 4, or other numbers of rods, are driven by motors or cylinders to lift and descend synchronously, and are equipped with mechanical stops and/or sensors for precise positioning.

The transfer plate 31 is provided with wafer carrier positions 311 for carrying wafer carriers 101 (which may be, for example, commonly used small graphite sub-susceptor). The filter plate 32 is provided with wafer filter through-holes 321. The molybdenum holder 200 is provided with wafer positions 203 for carrying wafers 100. The diameter of the wafer filter through-hole 321 is larger than the diameter of the wafer 100 and smaller than the diameter of the wafer carrier 101, so that in the flipping process of the combined carrier plates (the transfer plate 31, the filter plate 32, and the molybdenum holder 200), the wafer 100 can pass through the wafer filter through-hole 321, while the wafer carrier 101 cannot.

The sizes, quantities, and positions of wafers 100 supported by the wafer carrier positions 311 on the transfer plate 31, the wafer filter through-holes 321 on the filter plate 32, and the wafer positions 203 on the molybdenum holder 200 are individually mated with their respective counterparts. The transfer plate 31, the filter plate 32, and the molybdenum holder 200 are manufactured as a triplet (which may differ in specifications from the large graphite susceptor of the MOCVD system), and may be configured for, for example, 8 pieces of 6 inches, 3 pieces of 8 inches, 4 pieces of 6 inches, 9 pieces of 4 inches, etc. By adjusting the specifications of the carrier plates, compatibility with various types of MBE systems and MOCVD systems can be achieved. The diameter of the filter plate 32 is larger than the diameter of the transfer plate 31 and the diameter of the molybdenum holder 200. The upper and lower sides of the filter plate 32 are respectively provided with protrusions 325 matching the outer peripheral dimensions of the molybdenum holder 200 and the transfer plate 31. A placement portion 322 is formed on the inner side of the protrusion 325. When the molybdenum holder 200 and the transfer plate 31 are located in the placement portions 322, the protrusions 325 can be used for circumferential positioning of the molybdenum holder 200 and the transfer plate 31, preventing the molybdenum holder 200 and the transfer plate 31 from sliding in all directions. Precise positioning between the filter plate 32 and the transfer plate 31 is achieved by, but not limited to, the second positioning notch 323 on the filter plate 32 and the first positioning notch 312 on the transfer plate 31, so that the wafer filter through-holes 321 on the filter plate 32 correspond one-to-one with the wafer carrier positions 311 on the transfer plate 31. Precise positioning between the filter plate 32 and the molybdenum holder 200 is achieved by, but not limited to, the positioning pin 324 on the filter plate 32 and the positioning hole 201 on the molybdenum holder 200, so that the wafer filter through-holes 321 on the filter plate 32 correspond one-to-one with the wafer positions 203 on the molybdenum holder 200.

The flipping robot 61 is disposed in the robot box 6. The front end of the flipping robot 61 is provided with an upper clamping jaw 611 and a lower clamping jaw 612, capable of gripping and releasing a single carrier plate or combined carrier plates. The structure is simple and reasonable. The flipping robot 61 has 180° flipping and telescopic extension and retraction functions, and supports high temperature motion at 800°C in a vacuum environment.

The flipping robot 61 is made of high-purity and high-strength materials capable of withstanding a high temperature of 800°C, including but not limited to stainless steel, tantalum, molybdenum, ceramics, etc. The flipping robot 61 is preferably driven by a motor or cylinder. The motor or cylinder is disposed outside the vacuum chamber and transmits motion through magnetic coupling. The positioning of the flipping robot 61 is achieved by adopting means including but not limited to a positioning slot, and other positioning options such as mechanical positioning, photoelectric sensor positioning, or CCD camera vision positioning may also be adopted.

### Embodiment II

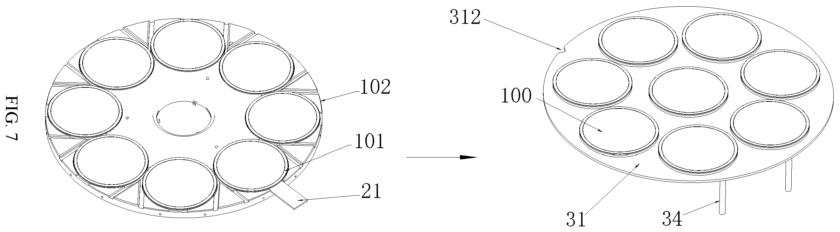

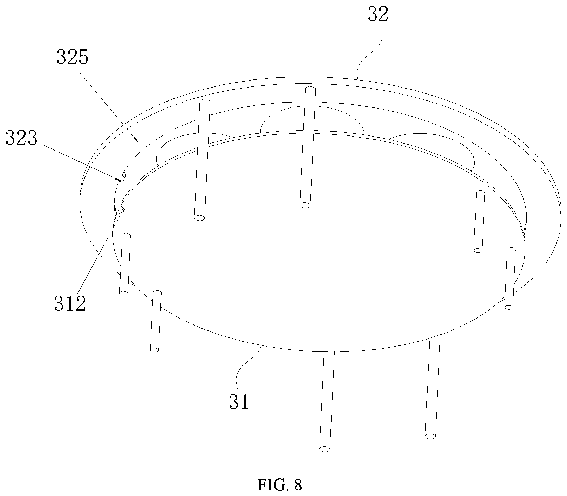

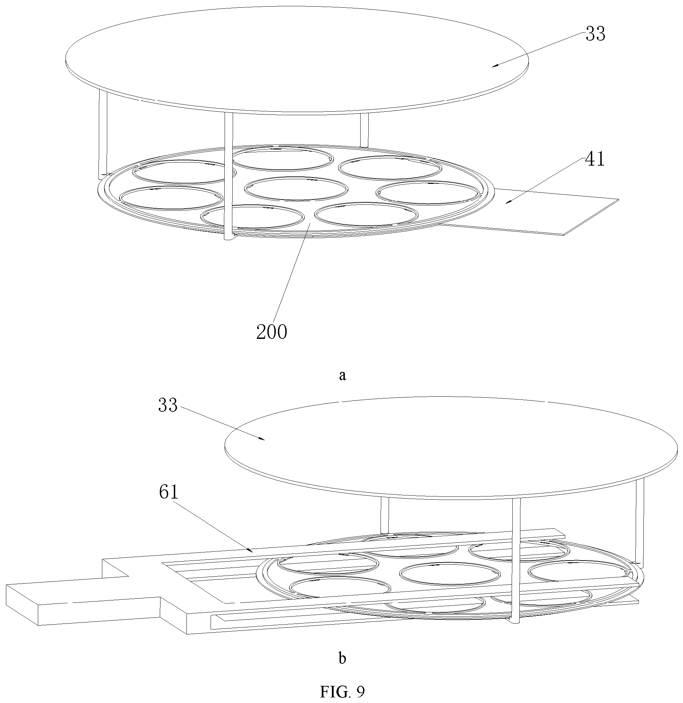

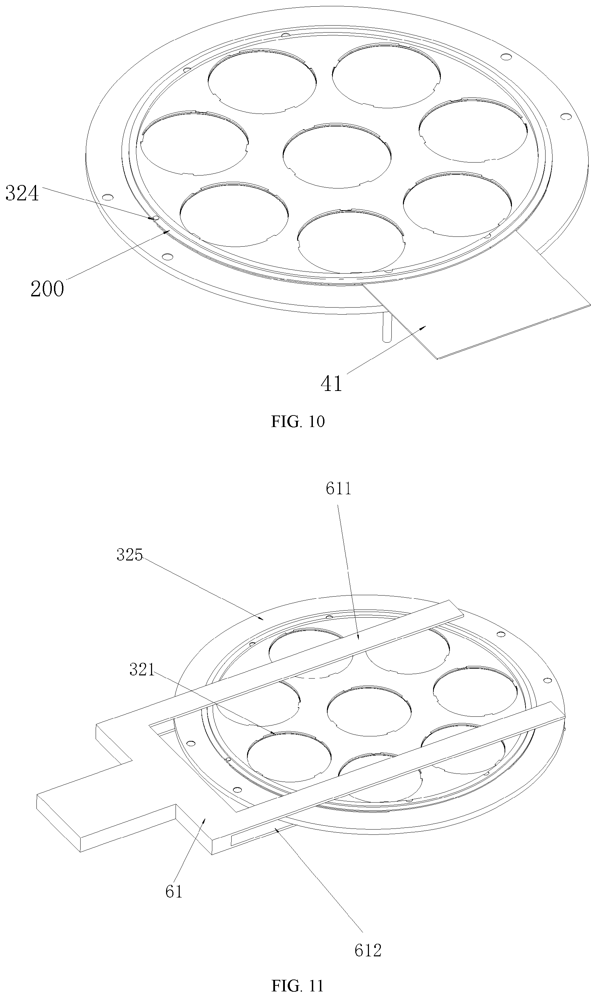

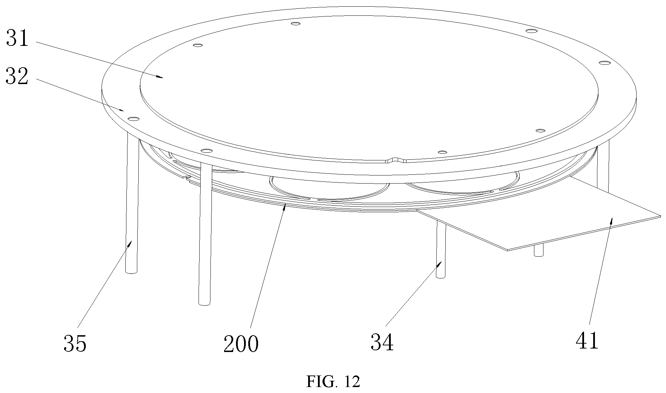

FIG. 7 to FIG. 12 show an embodiment of the method for sample exchange between MOCVD and MBE according to the present invention.

S1. An MOCVD growth chamber 1, an MOCVD transfer chamber 2, and a flipping chamber 3 are brought into communication. The three chambers are evacuated to reach or exceed a first predetermined vacuum degree. An MOCVD transfer chamber robot 21 takes wafer carriers 101 (with wafers 100, and the growth surfaces of the wafers 100 facing upward) one by one from a graphite susceptor 102 in the MOCVD growth chamber 1, and delivers them to wafer carrier positions 311 on a transfer plate 31 in the flipping chamber 3. This process is repeated until all wafer carriers 101 have been transferred. The MOCVD growth chamber 1, the MOCVD transfer chamber 2, and the flipping chamber 3 are isolated.

S2. Second support rods descend to bring a filter plate 32 down onto the transfer plate 31. Precise positioning between the filter plate 32 and the transfer plate 31 is achieved through a protrusion 325 at the edge of the filter plate 32, a second positioning notch 323 on the filter plate 32, and a first positioning notch 312 on the transfer plate 31.

S3. The flipping chamber 3 is evacuated to reach or exceed a second predetermined vacuum degree.

The flipping chamber 3 and an MBE transfer chamber 4 are brought into communication. An MBE transfer chamber robot 41 delivers an empty molybdenum holder 200 from an MBE chamber to a transfer stage 33 in the flipping chamber 3 and then retracts. The transfer stage 33 rotates by a certain angle (a specific angle is determined according to a chamber layout, and as described above, in this embodiment, it is 90°) until a wafer pick-up position is aligned with the direction of a flipping robot 61.

S4. The flipping robot 61 clamps the empty molybdenum holder 200 from the transfer stage 33, retracts to a suitable position, flips the empty molybdenum holder 200 by 180°, and returns it to the transfer stage 33. The transfer stage 33 rotates by a certain angle until the wafer pick-up position is aligned with the direction of the MBE transfer chamber robot 41 (if the empty molybdenum holder 200 that has already been flipped is initially placed in an MBE loading chamber, this step may be omitted).

S5. The MBE transfer chamber robot 41 retrieves the flipped empty molybdenum holder 200 and then retracts. The transfer stage 33 ascends to vacate space. First support rods ascend to lift the transfer plate 31 and the filter plate 32 thereabove to a height suitable for the MBE transfer chamber robot 41 to place sample. The MBE transfer chamber robot 41 delivers the flipped empty molybdenum holder 200 onto the filter plate 32. Precise positioning between the filter plate 32 and the molybdenum holder 200 is achieved through the protrusion 325 at the edge of the filter plate 32, a positioning pin 324 on the filter plate, and a positioning hole 201 on the molybdenum holder 200. The MBE transfer chamber robot 41 retracts.

S6. The flipping robot 61 clamps the tightly fitted combined carrier plates (which includes, from top to bottom, the molybdenum holder 200, the filter plate 32, and the transfer plate 31). The first support rods descend to separate from the transfer plate 31. The flipping robot 61 retracts to a suitable position and flips the combined carrier plates by 180°. The wafers 100 in the wafer carriers 101 on the transfer plate 31 fall through wafer filter through-holes 321 onto wafer positions 203 on a lowermost molybdenum holder 200. At this time, the growth surfaces of the wafers face downward.

S7. The flipping robot 61 returns the combined carrier plates (which, at this time, includes, from top to bottom, the transfer plate 31, the filter plate 32, and the molybdenum holder 200). The first support rods ascend to support the combined carrier plates (specifically, the molybdenum holder 200). The flipping robot 61 retracts. The second support rods ascend to lift the filter plate 32 and the transfer plate 31 thereabove, and separate them from the molybdenum holder 200. The MBE transfer chamber robot 41 holds the molybdenum holder 200 (with the wafers 100, and with the growth surfaces of the wafers 100 facing downward). The first support rods descend to separate from the molybdenum holder 200. The MBE transfer chamber robot 41 retrieves the molybdenum holder 200. The flipping chamber 3 and the MBE transfer chamber 4 are isolated. Thus, the sample transfer from MOCVD to MBE is completed.

S8. The MBE transfer chamber 4 is evacuated to reach or exceed a third predetermined vacuum degree. The MBE transfer chamber 4 and an MBE growth chamber 5 are brought into communication. The MBE transfer chamber robot 41 delivers the molybdenum holder 200 and the wafers 100 into the MBE growth chamber 5. The MBE transfer chamber 4 and the MBE growth chamber 5 are isolated. The MBE growth chamber 5 is evacuated to reach or exceed a fourth predetermined vacuum degree, and an MBE process is started.

S9. After the MBE process is completed, the MBE growth chamber 5 and the MBE transfer chamber 4 are brought into communication. The MBE transfer chamber robot 41 retrieves the molybdenum holder 200 from the MBE growth chamber 5. The MBE growth chamber 5 and the MBE transfer chamber 4 are isolated. The MBE transfer chamber 4 and the flipping chamber 3 are brought into communication. The MBE transfer chamber robot 41 returns the molybdenum holder 200 to the flipping chamber 3. The first support rods ascend to support the molybdenum holder 200. The MBE transfer chamber robot 41 retracts. The MBE transfer chamber 4 and the flipping chamber 3 are isolated. The second support rods descend to seat the filter plate 32 and the transfer plate 31 thereabove onto the molybdenum holder 200. The flipping robot 61 clamps the tightly fitted combined carrier plates (which includes, from top to bottom, the transfer plate 31, the filter plate 32, and the molybdenum holder 200). The first support rods descend to separate from the molybdenum holder 200. The second lifting assembly 35 descends to separate from the filter plate 32. The flipping robot 61 retracts to a suitable position and flips the combined carrier plates by 180°. The wafers 100 in the molybdenum holder 200 fall through the wafer filter through-holes 321 onto the wafer carriers 101 on a lowermost transfer plate 31. At this time, the growth surfaces of the wafers 100 face upward.

S10. The flipping robot 61 returns the combined carrier plates (which, at this time, includes, from top to bottom, the molybdenum holder 200, the filter plate 32, and the transfer plate 31). The first support rods ascend to support the combined carrier plates (specifically, the transfer plate 31). The flipping robot 61 retracts. The second support rods ascend to lift the filter plate 32 and the molybdenum holder 200 thereabove, and separate them from the transfer plate 31. The flipping chamber 3, the MOCVD transfer chamber 2, and the MOCVD growth chamber 1 are brought into communication. The MOCVD transfer chamber robot 21 takes the wafer carriers 101 (with the wafers 100, and with the growth surfaces of the wafers 100 facing upward) one by one from the transfer plate 31 in the flipping chamber 3, and delivers them to the graphite susceptor 102 in the MOCVD growth chamber 1. This process is repeated until all the wafer carriers 101 are transferred. The MOCVD growth chamber 1, the MOCVD transfer chamber 2, and the flipping chamber 3 are isolated. Thus, the sample transfer from MBE to MOCVD is completed.

During the transfer and flipping of the wafer 100, the present invention does not require contact with the growth surface of the wafer 100, thereby reducing the risk of surface damage and contact contamination of the wafer 100, and does not require clamping of the peripheral region of the wafer 100, thereby reducing the risk of fragmentation caused by compressive stress. The present invention enables clean, efficient, and safe transfer of the wafer 100 between carriers of different specifications, achieves bidirectional automatic sample transfer from MOCVD to MBE or from MBE to MOCVD, truly accomplishes vacuum interconnection and process interconnection between MOCVD and MBE, fully leverages the advantages of both types of equipment, significantly improves process performance and production efficiency, and provides possibilities for the development of special materials and novel devices.

Although the present invention has been disclosed above with reference to preferred embodiments, it is not intended to limit the present invention. Any person skilled in the art, without departing from the scope of the technical solution of the present invention, may make many possible variations and modifications to the technical solution of the present invention by using the technical content disclosed above, or may modify it into equivalent embodiments with equivalent changes. Therefore, any simple modifications, equivalent changes, and modifications made to the above embodiments in accordance with the technical essence of the present invention, without departing from the content of the technical solution of the present invention, shall fall within the scope of protection of the technical solution of the present invention.

## Claims

1. A vacuum interconnection system for sample exchange between MOCVD and MBE, **characterized in that** the system comprises: an MOCVD growth chamber (1), an MOCVD transfer chamber (2), a flipping chamber (3), an MBE transfer chamber (4), and an MBE growth chamber (5), which are sequentially docked with one another, wherein adjacent chambers are isolated from each other by isolation valves; the MOCVD transfer chamber (2) is provided with an MOCVD transfer chamber robot (21); the flipping chamber (3) is internally provided with a transfer plate (31), a filter plate (32), a transfer stage (33) which is liftable and rotatable, a first lifting assembly (34) detachably connectable to the transfer plate (31) or a molybdenum holder (200), and a second lifting assembly (35) detachably connectable to the filter plate (32); the transfer plate (31) is provided with a plurality of wafer carrier positions (311); the filter plate (32) is provided with a plurality of wafer filter through-holes (321); a diameter of the wafer filter through-hole (321) is larger than a diameter of a wafer (100) and smaller than a diameter of a wafer carrier (101); an upper surface of the filter plate (32) is provided with a placement portion (322) for placing the molybdenum holder (200), and a lower surface of the filter plate (32) is provided with a placement portion (322) for placing the transfer plate (31); one side of the flipping chamber (3) is docked with a robot box (6); the robot box (6) is internally provided with a flipping robot (61), and the MBE transfer chamber (4) is provided with an MBE transfer chamber robot (41).

2. The vacuum interconnection system for sample exchange between MOCVD and MBE according to claim 1, **characterized in that** a first positioning mechanism is provided between the transfer plate (31) and the filter plate (32), and a second positioning mechanism is provided between the filter plate (32) and the molybdenum holder (200).

3. The vacuum interconnection system for sample exchange between MOCVD and MBE according to claim 2, **characterized in that** the first positioning mechanism comprises a first positioning notch (312) provided on the transfer plate (31) and a second positioning notch (323) provided on the filter plate (32); and
the second positioning mechanism comprises a positioning pin (324) provided on the filter plate (32) and a positioning hole (201) provided on the molybdenum holder (200); or the second positioning mechanism comprises a positioning hole (201) provided on the filter plate (32) and a positioning pin (324) provided on the molybdenum holder (200).

4. The vacuum interconnection system for sample exchange between MOCVD and MBE according to claim 1, **characterized in that** the first lifting assembly (34) and the second lifting assembly (35) each comprise a plurality of lifting rods; the transfer plate (31), the molybdenum holder (200), and the filter plate (32) are provided with slots (202) for engaging with the lifting rods.

5. The vacuum interconnection system for sample exchange between MOCVD and MBE according to claim 1, **characterized in that** an outer periphery of the placement portion (322) is provided with a protrusion (325); the wafer filter through-holes (321) are located within the placement portions (322).

6. The vacuum interconnection system for sample exchange between MOCVD and MBE according to any one of claims 1 to 5, **characterized in that** the MOCVD transfer chamber robot (21), the MBE transfer chamber robot (41), the flipping robot (61), the transfer stage (33), the first lifting assembly (34), and the second lifting assembly (35) are all capable of moving at a high temperature up to 800°C in a vacuum environment.

7. The vacuum interconnection system for sample exchange between MOCVD and MBE according to any one of claims 1 to 5, **characterized in that** a drive part of the MOCVD transfer chamber robot (21) is located outside the MOCVD transfer chamber (2) and transmits motion through magnetic coupling; a drive part of the MBE transfer chamber robot (41) is located outside the MBE transfer chamber (4) and transmits motion through magnetic coupling.

8. The vacuum interconnection system for sample exchange between MOCVD and MBE according to any one of claims 1 to 5, **characterized in that** the flipping robot (61) comprises an upper clamping jaw (611) and a lower clamping jaw (612) separated by a predetermined gap.

9. A method for sample exchange between MOCVD and MBE, **characterized in that** the method comprises the following steps:
S1. bringing an MOCVD growth chamber (1), an MOCVD transfer chamber (2), and a flipping chamber (3) into communication, evacuating the three chambers to a first predetermined vacuum degree; using an MOCVD transfer chamber robot (21) to transfer each wafer (100) along with a wafer carrier (101) from a graphite susceptor (102) within the MOCVD growth chamber (1), to each wafer carrier position (311) of a transfer plate (31); isolating the MOCVD growth chamber (1), the MOCVD transfer chamber (2), and the flipping chamber (3);
S2. driving a filter plate (32) to descend and land on the transfer plate (31) by a second lifting assembly (35), and aligning wafer filter through-holes (321) with the wafer carrier positions (311);
S3. evacuating the flipping chamber (3) to a second predetermined vacuum degree, bringing the flipping chamber (3) and an MBE transfer chamber (4) into communication; taking an empty molybdenum holder (200) from the MBE transfer chamber (4) by an MBE transfer chamber robot (41); if the empty molybdenum holder (200) is already in a flipped state, proceeding directly to step S5; and if the empty molybdenum holder (200) is in an unflipped state, transferring the empty molybdenum holder (200) to a transfer stage (33) by the MBE transfer chamber robot (41), then retracting the MBE transfer chamber robot (41), and the transfer stage (33) rotating by a certain angle to align a wafer pick-up position with a flipping robot (61);
S4. taking the empty molybdenum holder (200) from the transfer stage (33) by the flipping robot (61), retracting the flipping robot by a certain distance; then flipping the empty molybdenum holder (200) by 180° and returning the empty molybdenum holder (200) to the transfer stage (33) by the flipping robot(61); the transfer stage (33) rotating by a certain angle to align the wafer pick-up position with the MBE transfer chamber robot (41), and retrieving a flipped empty molybdenum holder (200) by the MBE transfer chamber robot (41);
S5. ascending the transfer stage (33), ascending a first lifting assembly (34) to drive the transfer plate (31) and the filter plate (32) to a position suitable for the MBE transfer chamber robot (41); transferring the empty molybdenum holder (200) onto the filter plate (32) by the MBE transfer chamber robot (41); aligning wafer positions (203) on the molybdenum holder (200) with the wafer filter through-holes (321), and retracting the MBE transfer chamber robot (41);
S6. simultaneously clamping the transfer plate (31), the filter plate (32), and the molybdenum holder (200) by the flipping robot (61); descending the first lifting assembly (34) to separate from the transfer plate (31), retracting the flipping robot (61) by a certain distance and then performing flipping by 180°, letting the wafer (100) on the wafer carrier (101) to fall through the wafer filter through-hole (321) into the wafer position (203) on a lowermost molybdenum holder (200); and
S7. returning the molybdenum holder (200), the filter plate (32), and the transfer plate (31) by the flipping robot (61); ascending the first lifting assembly (34) to support the molybdenum holder (200), retracting the flipping robot (61); ascending the second lifting assembly (35) to lift the filter plate (32) and the transfer plate (31) thereabove, and separating them from the molybdenum holder (200); holding the molybdenum holder (200) by the MBE transfer chamber robot (41), descending the first lifting assembly (34) to separate from the molybdenum holder (200), and retrieving the molybdenum holder (200); and isolating the flipping chamber (3) and the MBE transfer chamber (4) by the MBE transfer chamber robot (41).

10. The method for sample exchange between MOCVD and MBE according to claim 9, **characterized by** further comprising steps of:
S8. evacuating the MBE transfer chamber (4) to a third predetermined vacuum degree, bringing the MBE transfer chamber (4) and an MBE growth chamber (5) into communication; transferring the molybdenum holder (200) to the MBE growth chamber (5) by the MBE transfer chamber robot (41); isolating the MBE transfer chamber (4) and the MBE growth chamber (5); evacuating the MBE growth chamber (5) to a fourth predetermined vacuum degree, and starting an MBE process;
S9. after the MBE process is completed, bringing the MBE growth chamber (5) and the MBE transfer chamber (4) into communication; retrieving the molybdenum holder (200) from the MBE growth chamber (5) by the MBE transfer chamber robot (41); isolating the MBE growth chamber (5) and the MBE transfer chamber (4), bringing the MBE transfer chamber (4) and the flipping chamber (3) into communication; transferring the molybdenum holder (200) to the flipping chamber (3) by the MBE transfer chamber robot (41); ascending the first lifting assembly (34) to support the molybdenum holder (200), retracting the MBE transfer chamber robot (41), isolating the MBE transfer chamber (4) and the flipping chamber (3); descending the second lifting assembly (35) to lift the filter plate (32) and the transfer plate (31) thereabove onto the molybdenum holder (200); simultaneously holding the molybdenum holder (200), the filter plate (32), and the transfer plate (31) by the flipping robot (61); descending the first lifting assembly (34) to separate from the molybdenum holder (200); descending the second lifting assembly (35) to separate from the filter plate (32), and retracting the flipping robot (61) by a certain distance and then performing flipping by 180°, letting the wafer (100) on the molybdenum holder (200) to fall through the wafer filter through-hole (321) into the wafer carrier (101) on a lowermost transfer plate (31); and
S10. returning the transfer plate (31), the filter plate (32), and the molybdenum holder (200) by the flipping robot (61); supporting the transfer plate (31) by the first lifting assembly (34); retracting the flipping robot (61), ascending the second lifting assembly (35) to lift the filter plate (32) and the molybdenum holder (200) thereabove, and separating them from the transfer plate (31); bringing the MOCVD growth chamber (1), the MOCVD transfer chamber (2), and the flipping chamber (3) into communication; transferring each wafer (100) with its wafer carrier (101) from the transfer plate (31) within the flipping chamber (3) to the graphite susceptor (102) within the MOCVD growth chamber (1) by the MOCVD transfer chamber robot (21); isolating the MOCVD growth chamber (1), the MOCVD transfer chamber (2), and the flipping chamber (3).
